# EUROPÄISCHE PATENTSCHRIFT

(11) **EP 0 904 549 B1**
(45) Veröffentlichungstag und Bekanntmachung des Hinweises auf die Patenterteilung: **19.02.2003**
(21) Anmeldenummer: 98916893.5
(22) Anmeldetag: 06.03.1998
(51) Int. Cl.: G01R 31/327

(54) **VERFAHREN ZUR PRÜFUNG VON DIFFERENTIALSCHUTZRELAIS/-SYSTEMEN**
METHOD FOR TESTING DIFFERENTIAL PROTECTION RELAYS OR DIFFERENTIAL PROTECTION RELAY SYSTEMS
PROCEDE DE CONTROLE DE RELAIS DE PROTECTION DIFFERENTIELS OU DE SYSTEMES DE RELAIS DE PROTECTION DIFFERENTIELS

(30) Priorität: 04.04.1997 DE 19713748
(43) Veröffentlichungstag der Anmeldung: 31.03.1999
(73) Patentinhaber: Omicron Electronics GmbH, 6844 Altach (AT)
(72) Erfinder: GRÜNERT, Hagen, D-14612 Falkensee (DE)
(74) Vertreter: Riebling, Peter, Dr.-Ing.
(86) Internationale Anmeldenummer: EP9801316
(87) Internationale Veröffentlichungsnummer: WO98045721

(56) Entgegenhaltungen:
- EP-A- 0 561 146
- DE-A- 2 735 811
- US-A- 4 177 419
- DATABASE WPI Week 8730 Derwent Publications Ltd., London, GB; AN 87-211910 XP002043580 & SU 1 270 778 A (NOVOS ELECTROTECH INST) , 15.November 1986
- IGEL M ET AL: "PRUEFUNG VON SCHUTZEINRICHTUNGEN" ELEKTROTECHNISCHE ZEITSCHRIFT - ETZ, Bd. 116, Nr. 18, Seiten 14-16, 18, 20, 22, XP000535314
- DATABASE WPI Week 8136 Derwent Publications Ltd., London, GB; AN 1981-J3424D XP002043581 "TESTING CURRENT CIRCUIT RELAY PROTECT SYSTEM..." & SU 779 930 A (ENERGOSETPROEKT) ,

## Beschreibung

Gegenstand der Erfindung ist ein Verfahren zur Prüfung von Differentialschutzrelais/-systemen nach dem Oberbegriff des Patentanspruchs 1. Derartige Differentialschutzrelais/-systeme werden als Schutzeinrichtung zur Überwachung verschiedenartigster Betriebsmittel in der Energietechnik verwendet. Derartige Betriebsmittel können z. B. sein ein Hochspannungs- oder Mittelspannungstransformator, eine Sammelschiene, ein Generator, eine Leitung/Kabel und dgl. Teile der Energietechnik mehr. Derartige Betriebsmittel der Energietechnik werden aus Sicherheitsgründen mit Differentialschutzrelais versehen, welche die Aufgabe haben, in einem Störfall des zu schützenden Betriebsmittels dieses von dem Energienetz zu trennen.

Gegenstand der vorliegenden Erfindung ist ein Verfahren und zur Überprüfung derartiger Differentialschutzrelais und Differentialschutzsysteme, mit dem Ziel, die Funktion derartiger Differentialschutzrelais und Differentialschutzsysteme (die Gewährleistung deren Schutzfunktion) zu sichern.

Dabei muß die Funktionsprüfung bei anlagenspezifischer Parametrierung/Einstellung des Differentialschutzrelais möglich sein.

Mit dem vorgestellten Prüfverfahren ist es möglich, die Richtigkeit der anlagenspezifischen Projektierung, Parametrierung/Einstellung und Verdrahtung des Differentialschutzrelais bzw. Differentialschutzsystems und dessen Schutzfunktion nachzuweisen.

Weiterer Gegenstand der Erfindung ist der Ersatz und die Verbesserung bisher durchgeführter Primärprüfverfahren, wie z.B. die 380 Volt-Methode, welche wegen der kleinen Prüfgrößen nur eingeschränkte und oft mißverständliche Aussagen zuließen.

Die Bezeichnung Differentialschutzsystem beinhaltet, insbesondere bei der Verwendung von konventionellen Differentialschutzeinrichtungen, die Anpasswandlerschaltung.

Derzeit werden numerische Differentialschutzeinrichtungen mit durch Software realisierter Schaltgruppenanpassung und Nullstromelimination fast ausschließlich durch eine einseitige Stromeinspeisung an einem einzigen Punkt im Kennlinienfeld geprüft, was keine verlässliche Aussage über die Funktionstüchtigkeit des Differentialschutzrelais zulässt. Einzelne große Energieversorgungsunternehmen (EVU) prüfen Differentialschutzrelais durch eine zweiseitige Stromeinspeisung mit zwei regelbaren Stromquellen, wobei die Stromvektorberechnung und Prüfanschaltung aufwendig ist und spezielle Kenntnisse voraussetzt, sowie auf die ein- und zweipolige Fehlersimulation beschränkt ist. Abschließend prüfen letztere EVU die Richtigkeit der Projektierung, Parametrierung/Einstellung und Verdrahtung des Differentialschutzsystems speziell an Transformatoren mit einem dreiphasigen Primärprüfverfahren (380 Volt-Methode). Prüfungen im Kennlinienfeld erfolgen auch beim Schutzgerätehersteller mit zwei Stromgeneratoren und parametrierter Schaltgruppe Yy0 bzw. Yy6.

Derartige bekannte Prüfverfahren lassen sich z.B. der "IEEE Guide for Differential and Polarizing Relay Circuit Testing", IEEE C37.103-1990, ISBN 1-55937-058-0, Seiten 21 ff. entnehmen.

Die bekannten Prüfanweisungen zeigen, daß mit einfachsten Mitteln geprüft wird. In der Regel werden einige Formeln sowie Stromtabellen für eine einfache Überprüfung des Relais angegeben. Die Prüfung erfolgt meist durch einseitige Stromeinspeisung. Fallweise wird ein zweiter Stromgenerator verwendet, um den Stabilisierungsstrom unabhängig vom Differentialstrom einstellen zu können.

Eine komplette Überprüfung des Relais und Schutzsystems ohne Umverdrahtung sowie die Prüfung der gesamten Stabilisierungskennlinie ist in keinem Fall möglich. Die bekannte 380 Volt-Prüfung ist aufgrund örtlicher Bedingungen nicht immer durchführbar und die möglichen Prüfströme sind oft zu klein, um eindeutige Aussagen treffen zu können.

Im Artikel von Igel, M und Schegner, P. "Prüfung von Schutzeinrichtungen" der Elektrotechnischen Zeitschrift-ETZ, Bd. 116, Nr. 18, Seiten 14-16,18,20,22, XP000535314, ist ein Verfahren zur Prüfung von Differentialschutzeinrichtungen beschrieben, bei welchem das durch die Differentialschutzeinrichtung zu schützende Betriebsmittel mit allen seinen wichtigsten Parametern mittels einer Software in einer Prüfeinrichtung simuliert wird. Hierbei werden die in der Simulation berechneten, vom zu schützenden Betriebsmittel und weiteren Parametern abhängigen Prüfströme an die an die Prüfeinrichtung angeschlossene Schutzeinrichtung ausgegeben. Durch die Prüfeinrichtung wird anhand der angelegten Prüfströme das Betriebs- und Fehlerverhalten der Schutzeinrichtung erfasst und entsprechend der spezifizierten Toleranzangaben der Schutzeinrichtung ausgewertet.

Aufgabe der vorliegenden Erfindung ist es, ein Verfahren der eingangs genannten Art so weiterzubilden, daß bei einem Differentialschutzrelais/-system sämtliche für die Schutzfunktion relevanten Parameter in einfacherer und genauerer Weise geprüft werden können und damit eine vollständige Prüfung möglich ist.

Zur Lösung der gestellten Aufgabe ist die Erfindung durch die Merkmale des Anspruchs 1 gekennzeichnet.

Es wird ein Prüfverfahren vorgeschlagen, welches eine 3-phasige Ankopplung des jeweiligen Drehstromsystems auf der Primär-, Sekundär- und ggf. Tertiärseite (6-9 Stromgeneratoren) vorsieht, plus ggf. der zusätzlichen Ankoppelung von separaten Nullströmen.

Der Prüfling wird einmal angeschlossen und kann in seiner kompletten Funktionalität überprüft werden. Die Überprüfung erfolgt nicht anhand irgendwelcher manuell errechneten oder aus einer Tabelle abgelesenen Stromwerte, sondern direkt unter Verwendung der Auslösekennlinie/Stabilisierungskennlinie I_{DIFF}/I_{STAB} (Operating Characteristic I_{DTFF}/I_{BIAS}), mit I_{DIFF} = Differentialstrom und I_{STAB} = Stabilisierungsstrom, bzw. der angepassten (virtuellen) Ströme Iₛ = f (Iₚ). Die Berechnung der Stromvektoren erfolgt automatisch unter Berücksichtigung des zu schützenden Betriebsmittels, der Stromwandlerverhältnisse, der Fehlerart und des Fehlerortes.

Mit diesem neuen Prüfverfahren werden Möglichkeiten einer funktions- und schutzobjektbezogenen Prüfung von Differentialschutzsystemen geschaffen. Es erlaubt die Prüfung spezieller Parameter von Leitungsdifferential- und Sammelschienenschutzgeräten sowie von Transformatoren-, Generator- und Motordifferentialschutzgeräten, die die Meßgröße Strom von allen galvanisch verbundenen Schutzobjektenden bezüglich ihrer Stromdifferenz oder Phasenwinkeldifferenz verarbeiten. Die Komplexität des Schutzobjektknotenpunktes ist auf drei Beine beschränkt.

Grundlage sämtlicher stationärer Prüfverfahren ist das Modell eines Transformators mit drei Wicklungen. Die anderen Schutzobjekte können mit diesem Modell bei spezifischer Parameterwahl ebenfalls simuliert werden. Die Zuordnung der Spannungsebenen bleibt fix. Als Primärseite (P) wird immer die linke Wicklung mit Speisemöglichkeit verwendet. Sekundärseite (S) ist immer die rechte Wicklung mit Speisemöglichkeit. Nur beim Dreiwickler bzw. beim Dreibein (Sammelschiene) kann die Tertiärseite (T) als reine Fehleroder Lastseite verwendet werden.

Wesentliches Merkmal der Erfindung ist, daß das Schutzobjekt mittels Software simuliert wird, so daß es mit seinen wichtigsten Parametern nachgebildet wird. Diese Simulation des Schutzobjektes geschieht in der Prüfeinrichtung selbst. Die in der Simulation berechneten Ströme werden anschließend an das an der Prüfeinrichtung angeschlossene Differentialschutzrelais/-system ausgegeben.

Für die Prüfung wird in diesem Fall die Prüfeinrichtung mit 6 bis 9 Stromgeneratoren anstelle der Stromwandler direkt an das zu prüfende Schutzrelais/-system angeschlossen. Eine Simulation des Trafoverhaltens erfolgt in der Prüfeinrichtung, und die errechneten Stromvektoren werden dem zu prüfenden Schutzrelais/-system zugeführt:

Es wird nun nachfolgend ein Verfahren zur Prüfung der Schaltgruppenanpassung und Betragskorrektur erläutert.

Die Meßströme der einzelnen Wicklungen sind beim Transformator durch die wirksame Schaltgruppe und Schaltziffer bedingt, in ihrer Phasenlage zueinander verschieden. Bei Stern/Dreieck-Transformatoren, Verwendung von Stufenschaltern, sowie wegen den voneinander abweichenden Verhältnissen I_{NWandler}/I_{NTrafo} der zu vergleichenden Wicklungen sind ebenfalls die Beträge der Meßströme verschieden. Der Stromvergleich muß somit auf die in den einzelnen Strängen fließenden Ströme oder auf eine Bezugswicklung zurückgeführt werden.

Die richtige Berechnung der zu vergleichenden Ströme aus den gemessenen sekundären Leiterströmen wird durch das hier beschriebene Prüfverfahren nachgewiesen. Weiters wird eine Kontrolle der richtigen Schutzgeräteparametrierung bzw. die richtige Projektierung und Umsetzung des Schutzsystems sowie der Gerätefunktion hinsichtlich der Meßgrößenanpassung durchgeführt. Die richtige Schutzgerätefunktion wird bei identischer Parametrierung des Schutzgerätes und der Prüfumgebung geprüft.

In dem hier beschriebenen wird das ideale Schutzobjekt ohne Beachtung der Einflüsse: Spannungsregelung, Kupfer- und Eisenverluste oder Ladeströme simuliert.

Basis der Vektorberechnung ist das Modell eines Dreiwicklungstransformators mit umschaltbarer Speiseseite. Für durchfließende Fehler kann nur einseitig eingespeist werden. Als Speiseseite kann die Primär- oder Sekundärwicklung gewählt werden. Die Speiseseite wird nach erfolgter Fehlerortanwahl automatisch umgeschaltet. Bsp. Fehler auf P-Seite -> Einspeisung auf S-Seite.

Die Standardfehlerarten 1polig, 2polig, 3polig sowie der 3polige Betriebszustand sind im Bereich O-I_{Ntrafo} 100%/Uₖ als durchfließende Ströme in der manuellen Betriebsart realisiert. Beim Dreiwicklertrafo kann auf einer Wicklung ein dreiphasiger Lastzustand, auf der jeweils anderen zusätzlich ein Fehlerfall gewählt werden. Dadurch wird der Prüfling an allen Enden gleichzeitig mit Meßgrößen beaufschlagt. Die Prüfgrößen der Einspeiseseite werden aus den Prüfgrößen der Last- bzw. Fehlerseite über das aufgezeigte Transformatormodell berechnet.

Nachfolgend wird ein Verfahren für die Prüfung der Auslösekennlinie I_{DIFF} = f (I_{STAB}) geschildert.

Die Erkennung eines Fehlers im Schutzbereich hängt nicht allein von der Größe eines fließenden Differentialstromes I_{DIFF} = |I_{P} - I_{S}| ab. Während des Betriebszustandes und bei außenliegenden Fehlern treten Differentialströme auf, deren Ursachen im
- Magnetisierungsstrom
- Einfluß des Stufenschalters
- Übersetzungsfehler der Wandler
zu finden sind und möglicherweise ein falsches Abbild über den Zustand des Schutzobjektes geben. Deshalb ist es wichtig, eine entsprechend stabilisierende Größe I_{STAB} = |I_{P}| + |I_{S}| zu verwenden (oder ähnliche Definitionen). Die fortfahrend beschriebenen Größen I_{P} und I_{S} sind virtuelle Größen die nicht unmittelbar aus dem Berechnungsmodell ersichtlich sind und als Eingangsgrößen für die Berechnung in der Diff/Stab-Ebene im Schutzgerät dienen. Sie sind Ausgangspunkt der Prüfgrößenberechnung.
- Die Überprüfung der beschriebenen Funktion muß bei anlagenspezifisch parametrierten Schutzgerät möglich sein und dient dem Nachweis der parametrierten Auslösekennlinie. Dabei soll die Auslösekennlinie durch Auswertung des Auskommandos über Binäreingabe für die Standardfehlerarten aufgenommen werden können. Das bedeutet, die Funktion basiert auf einer mehrseitigen und je nach Fehlerfall jeweils mehrpoligen Prüfung.
- Die Prüfung erfolgt bei konkreten Fehlerbedingungen (z. B. 2-poliger Fehler auf der Sekundärseite), welche über das Sinnbild des Schutzobjektes gemäß dem Berechnungsmodell in diese Funktion übernommen werden.
- Die Prüfung erfolgt automatisch oder manuell in der DIFF-STAB-Ebene (siehe Prüfumgebung).
- Zwei Verfahren sollen wählbar sein. Der erforderliche Differenzstrom wird durch einen reinen Betragsunterschied der zu vergleichenden Ströme I_{P}, I_{S} erzeugt.
- Für den einpoligen Fehler ist ein Parameter vorzusehen, der die Behandlung des Nullsystems im Schutzgerät berücksichtigt. Arbeitet das Schutzgerät mit eigener Nullstrommessung, so müssen keine Besonderheiten berücksichtigt werden. Wenn der berechnete Nullstrom aus den gemessenen Leiterströmen heraus gerechnet wird, so müssen die aus den gewählten DIFF- und STAB-Werten berechneten I_{P}, I_{S} mit dem Faktor 3/2 intern multzipliziert werden.

Die Erfindung hat aufgrund der vorstehenden Erläuterungen folgende Vorteile gegenüber dem Stand der Technik:
- Es sind keine Umverdrahtungen notwendig für leiterselektive Prüfungen unter verschiedenen Fehlerarten.
- Es sind keine komplizierte manuelle Berechnung der erforderlichen Stromvektoren erforderlich.
- Prüfbarkeit von Transformator-Differentialschutzeinrichtungen bei allen Schaltgruppen und dreipoligem Fehler.
- koordinierte Ausgabe von bis zu 9 (bzw. 11) Prüfströmen.
- Prüfung der Schutzgeräteparametrierung numerischer Relais und der Projektierung/Umsetzung konventioneller Differentialschutzsysteme durch Schutzobjektsimulation unter wesentlich günstigeren Meßbedingungen als vergleichsweise bei der 380 Volt-Methode.
- Ersatz der 380 Volt-Methode mit ihrem Nachteil der begrenzten Prüfstromhöhe durch Kombination bestehender Prüfverfahren mit dem hier beschriebenen.
- Das Prüfverfahren erlaubt ein direktes Arbeiten im Kennlinienfeld der Auslösecharacteristik (operating characteristic).
- Verfahren zur Überprüfung des Stabilisierungsverhaltens von Differentialschutzeinrichtungen bei beliebigen Normalbetriebszuständen sowie außenliegenden Fehlern.

Die wesentlichen Merkmale der vorliegenden Erfindung liegen also in folgender technischer Lehre:
- Prüfverfahren, bei dem eine 3-phasige Ankopplung der Prüfströme an jedem Bein/Wicklung (z. B. primär-, sekundär- und tertiärseitige Einspeisung bei einem 3-Wickler Transformatorschutz-Relais) der zu prüfenden Anordnung erfolgt, sowie wahlweise auch der Anschluß separater Nullströme. Eine Prüfung erfolgt somit mit 6 bis 9 (bzw. 11) Stromgeneratoren.
- Prüfverfahren von Differentialschutzeinrichtungen, bei welchem die Vorgabe der Prüfgrößen in der transformierten Ebene der Auslösekennlinie in Form von Idiff und Istab Werten erfolgt und welches unter Berücksichtigung des gewählten zu schützenden Objektes (Leitung, Sammelschiene, Transformator, Generator, Block) und seiner Parameter (Schaltgruppe, Wandlerübersetzungsverhältnisse, Sternpunkterdung etc.) für alle einfachen Fehlerarten automatisch die geeigneten Stromgrößen über eine Prüfeinrichtung an die Eingänge der zu prüfenden Einrichtung (digitales Schutzrelais oder konventionelles Schutzrelais incl. Anpaßwandler) anlegt.
- Funktions- und schutzobjektbezogene Prüfung von Differentialschutzgeräten und Systemen und Ersatz bzw. Verbesserung der bisher verwendeten 380 Volt-Methode.

Das Verfahren dient der Prüfung der Betrags- und Schaltgruppenkorrektur sowie Nullstromelimination insbesondere bei Inbetriebnahmen.

Aus der obenstehenden Darstellung ergibt sich also, daß der Kern der vorliegenden Erfindung darin liegt, daß nun erstmals eine funktions- und auch schutzobjektbezogene Prüfung von Differentialsschutzsystemen, insbesondere von Differentialsschutzrelais ausgeführt werden kann. Dies war beim Stand der Technik nicht möglich.

Die Prüfung der Auslösecharakteristik erfolgt durch zweiseitige Stromeinspeisung (primär und sekundär oder primär und tertiär). Bei drei Wicklungen kann die Sekundär- oder Tertiärwicklung ausgewählt werden.

Grundsätzlich muß unterschieden werden, welche Größen zur Berechnung des Wertepaares I_{DIFF} und I_{STAB} im Schutzgerät verwendet werden
- Die Berechnung des Wertepaares I_{DIFF} und I_{STAB} erfolgt im Strang der Bezugswicklung. Die zur Berechnung verwendeter Ströme I_{P}, I_{S}, I_{T} sind identisch zu den Strangströmen I_{PS}, I_{SS} und I_{IS} der Bezugswicklung.
- Die Berechnung des Wertepaares I_{DIFF} und I_{STAB} erfolgt bei den meisten Relaisherstellern (Siemens, AEG, ABB) in den Leitern einer Bezugsseite. Die Bezugsseite ist in der Prüfumgebung einstellbar, defaultmäßig ist die Primärwicklung (Wicklung 1 im Schutzgerät) zu wählen.

Differentialrelais arbeiten leiterselektiv. Um eine sinnvolle Stromverteilung in den einzelnen Phasen zu haben, werden die relativen Winkel- und Betragsbeziehungen beim außenliegenden Fehler der Berechnung zu Grunde gelegt. Wird die Bezugswicklung als Fehlerseite definiert, entspricht die Stromaufteilung dem Fehlerstromvektor I_{F}. Für die Fehler auf der dem Bezugspunkt abgewandten Seite muß die resultierende Stromaufteilung der Bezugsseite berechnet werden. Diese Stromaufteilung in den einzelnen Phasen, welche aus der gewählten Fehlerart I_{F} und Schaltgruppe SGₓ resultiert, ist durch Ermittlung der Strommatrix M über das Modell vor jeder Prüfung mit geänderter Schaltgruppe bzw. Fehlerart auf der Fehlerseite zu rechnen. In der sogenannten Strommatrix M ist der relative Betrag und die vektorielle Lage der Phasen qualitativ zu speichern. Für dieses Prüfverfahren sind im Gegensatz zum weiter oben beschriebenen Verfahren die besetzten Koeffizienten der Fehlerstromvektoren I_{F} nicht immer eins.

Problematik: Da beim zweipoligen Fehler auf der Dreieckseite auf der Sternseite zwei Ströme vom halben Betrag des dritten sind, wird die Kennlinie an zwei Punkten gleichzeitig geprüft. Beide Wertepaare haben den gleichen Anstieg. Je nach Ort in der Diff/Stab-Ebene muß auf den minimalen oder den maximalen Leiterstrom normiert werden.

Der Erfindungsgegenstand der vorliegenden Erfindung ergibt sich nicht nur aus dem Gegenstand der einzelnen Patentansprüche, sondern auch aus der Kombination der einzelnen Patentansprüche untereinander.

Alle in den Unterlagen, einschließlich der Zusammenfassung, offenbarten Angaben und Merkmale, insbesondere die in den Zeichnungen dargestellte räumliche Ausbildung werden als erfindungswesentlich beansprucht, soweit sie einzeln oder in Kombination gegenüber dem Stand der Technik neu sind.

Im folgenden wird die Erfindung anhand von lediglich einen Ausführungsweg darstellenden Zeichnungen näher erläutert. Hierbei gehen aus den Zeichnungen und ihrer Beschreibung weitere erfindungswesentliche Merkmale und Vorteile der Erfindung hervor.

Es zeigen:
- Figur 1:: Schematisiert die Darstellung eines Schutzobjektes mit dem zu überprüfenden Differentialschutzrelais;
- Figur 2:: Eine gegenüber Figur 1 konkretisierte Ausführungsform für ein numerisches Relais und Stromzählpfeildefinition;
- Figur 3:: Die Anschaltung von Prüfgrößen an ein konventionelles Differentialschutzrelais;
- Figur 4:: Eine genauere Darstellung der erfindungsgemäßen Prüfeinrichtung mit Anschaltung an die zu überprüfenden Differentialschutzrelais;
- Figur 5:: Diagramm der betrieblichen Differentialstromkennlinie in Abhängigkeit von verschiedenen Parametern;
- Figur 6:: Darstellung des Prüfverfahrens in der Ebene nach der Figur 5;
- Figur 7:: Kennlinienfeld der angepassten Vergleichsströme unter Beachtung gleicher Winkel.

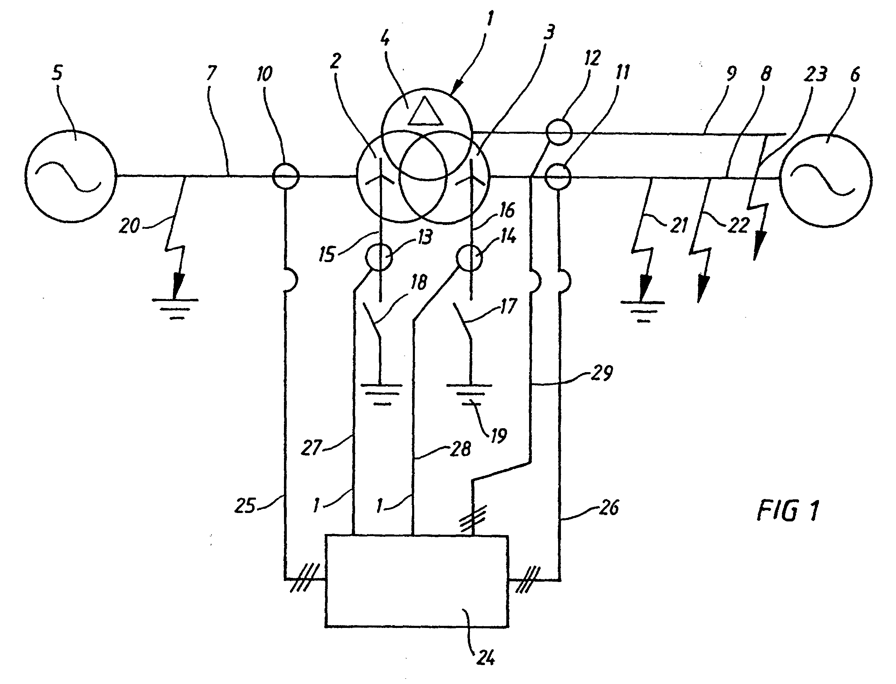

In Figur 1 ist schematisiert ein Schutzobjekt 1 dargestellt, welches in dem konkreten Ausführungsbeispiel, ein Generator, ein Transformator oder ein anderes Betriebsmittel sein kann. Im gezeigten Ausführungsbeispiel besteht das Schutzobjekt aus einem Transformator mit einer Primärwicklung 2, einer Sekundärwicklung 3 und einer Tertiärwicklung 4. Die genannten Wicklungen 2-4 können im Stern, Zick-Zack oder im Dreieck verkettet sein.

Primärseitig erfolgt eine Einspeisung 5 von einem Drehstromgenerator über die Drehstromleitung 7. Es ist schematisiert dargestellt, daß im Verlaufe dieser Leitung Fehler auftreten können, wie sie z. B. am Fehlerort 20 durch einen symbolisierten Kurzschluß dargestellt sind.

Sekundärseitig erfolgt die Einspeisung 6 ebenfalls über einen Drehstromgenerator über die Drehstromleitung 8.

Es kann zusätzlich noch auf der Drehstromleitung 9 ein Fehler oder eine Last 23 simuliert werden.

Es versteht sich von selbst, daß das Schutzobjekt 1 auch nur eine Primärwicklung 2 und eine Sekundärwicklung 3 aufweisen kann, und die Tertiärwicklung 4 entfällt.
Ebenso versteht es sich von selbst, daß das Schutzobjekt auch ein beliebiges anderes Betriebsmittel, z. B. eine Sammelschiene, eine Leitung/Kabel, ein Generator oder dgl. sein kann.

Die Sternpunkte der genannten Wicklungen 2,3 können auch mittels Leitungen 15,16 über zugeordnete Schalter 17,18 mit der Erde 19 verbindbar sein.

Der Schalter 17 soll darstellen, daß der Sternpunkt der Wicklung 3 geerdet oder nicht geerdet ist. An den Leitungen 15, 16 sind Erdstromwandler 13, 14 angeordnet.
Ebenso sind in den anderen Drehstromleitungen 7-9 Stromwandler 10-12 angeordnet, welche die entsprechende Signalumwandlung auf Sekundärgrößen vornehmen, um die entsprechenden Eingangskreise für das zu überprüfende Differentialschutzrelais 24 zu bilden.

Es ist im übrigen auch noch symbolisiert, daß im Bereich der Drehstromleitungen 8,9 entsprechende weitere Fehlerorte 21,22 vorhanden sein können.
Es kann sich hierbei jeweils um einen einpoligen Fehler handelt, um einen zwei- bis dreipoligen Fehler oder auch um eine 3-phasige Last, welche an der Drehstromleitung 7-9 anliegt.

Über die genannten Stromwandler 10-14 werden die Leitungen 25-29 als Signaleingänge an das Differentialschutzrelais 24 geführt.

Die Leitungen 25,26,29 sind hierbei 3-phasig ausgebildet.

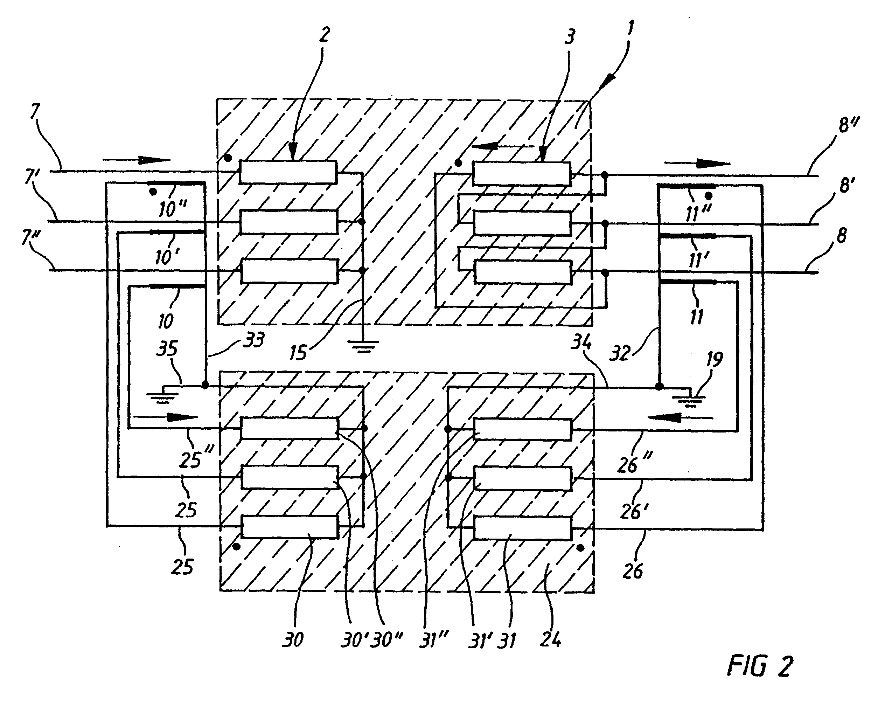

Die Figur 2 zeigt gegenüber der Figur 1 ein konkretisiertes Ausführungsbeispiel, wobei erkennbar ist, daß das Schutzobjekt 1 als ein mit Primärwicklungen 2 und Sekundärwicklungen 3 ausgebildeter Transformator ausgebildet ist, wobei die Primärwicklung als Sternwicklung und die Sekundärwicklung als Dreieckswicklung ausgebildet ist.

Das zu prüfende Differentialschutzrelais 24 ist über die bereits schon in Figur 1 erläuterten Leitungen 25, 26 mit dem Schutzobjekt 1 verbunden.

Für die gleichen Teile gelten die gleichen Bezeichnungen, so daß auf eine Erläuterung dieser Teile verzichtet wird.

Das hier gezeigte Differentialschutzrelais besteht aus einem primärseitigen Eingangswandler 30 mit den Eingangswicklungen 30,30',30'', während der sekundäre Eingangswandler 31 ebenfalls die Wicklungen 31,31',31'' aufweist.

Von dem primärseitigen Stromwandler 10, der 3-phasig ausgebildet ist (10,10',10'') führen nun die zugeordneten Leitungen 25,25',25" zu den vorher erwähnten Eingangswicklungen der Eingangswandler 30.

Gleiches gilt für die Sekundärseite, wo ebenfalls die Leitungen 26,26',26'' an die Eingangswandler 31,31',31'' angeschlossen sind. Über die Leitungen 34,35 erfolgt die Verbindung zur Erde 19, wobei die Stromwandler 10,11 ebenfalls über Leitungen 32,33 mit der Erde 19 verbunden sind.

Auf diese Weise wird dem Schutzrelais also durch die Eingangswandler 30,31 jeweils ein Strom I'_{PL} bzw. I'_{SL} eingeprägt, wobei diese Ströme die transformierten Primärströme I_{PL} und I_{SL} sind.

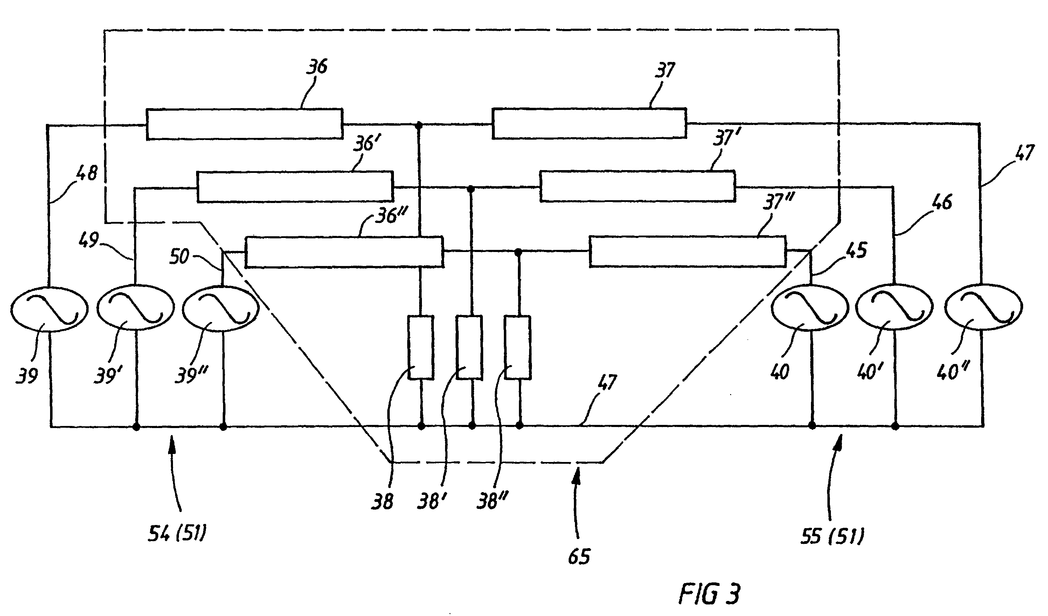

Die Figur 3 zeigt die Ankopplung von Prüfgrößen an ein konventionelles Differentialrelais 65 mit symmetrischen primär- und sekundärseitigen Haltewicklungen 36,37 und dazwischen angeordneten Differentialwicklungen 38.

Die Prüfgrößen (Prüfströme) werden mittels Stromgeneratoren 39,39'39'' primärseitig an die zugeordneten Haltewicklungen 36 angelegt, während sekundärseitig ebenfalls über Stromgeneratoren 40,40',40'' die entsprechenden Prüfgrößen an die Haltewicklungen 37,37',37'' angelegt werden.

Wichtig ist, daß die genannten Stromgeneratoren 39,40 Teil der erfindungsgemäßen Testanordnung 54,55 ist, die ihrerseits Bestandteil der erfindungsgemäßen Prüfeinrichtung 51 ist.

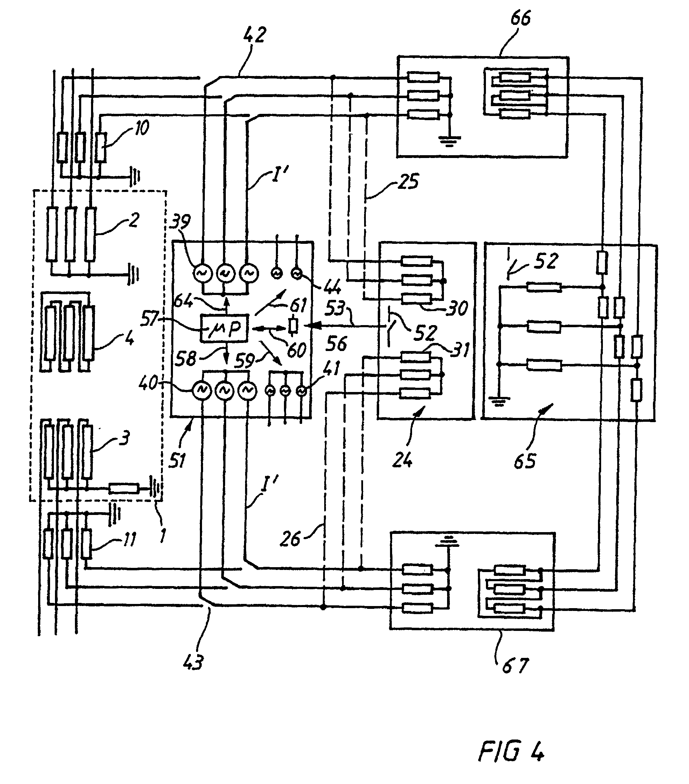

Anhand von Figur 4 wird noch näher erläutert werden, daß es wesentlich für die Erfindung ist, daß die genannten Stromgeneratoren 39,40 nach der Figur 3 digital angesteuert werden und nun ein in freien Grenzen vorgebbares Prüfprogramm ausführen, mit dem es möglich ist, sämtliche stromdurchflossenen Teile des zu prüfenden numerischen Differentialschutzrelais bzw. konventionellen Differentialschutzsystems zu prüfen und zwar nach Vorgaben unterschiedlichster Parameter.
Dies ist in Figur 4 näher dargestellt.

Figur 4 zeigt den praktischen Anschluß eines digitalen Differntialrelais 24 bzw. eines konventionellen Differentialrelais 65 incl. Anpasswandler 66, 67 an die primären und sekundären Stromwandler 10, 11 des zu schützenden Transformators 1 mit seiner Primärwicklung 2, Sekundärwicklung 3 und Tertiärwicklung 4. Es ist ersichtlich, daß numerische Relais 24 keine Halte- und Differentialwicklungen enthalten und nur den Leiterstrom über die Geräteeingangswandler 30, 31 messen.

Das Differentialschutzsystem 65 bzw. das numerische Differentialschutzrelais 24 kann bis zu 11 Ströme von drei Wicklungen und zwei Erdstromwandlern verarbeiten. Dem trägt die Prüfeinrichtung 51 mit ebenfalls bis zu 11 unabhängigen von einem Mikroprozessor 57 gesteuerten Stromgeneratoren 39-41, 44 Rechnung. Jeder Stromgenerator 39-41, 44 wird mit einem Relaiseingangswandler 30, 31 bzw. Anpasswandler 66, 67 verbunden. Die von der Prüfeinrichtung 51 anhand des Modells des jeweiligen zu schützenden Betriebsmittels 1 berechneten Ströme werden nach deren Anschaltung über die Klemmleiste oder Prüfschalter 42, 43 an die primär-, sekundär- und ggf. tertiärseitigen Geräteeingangswandler 30, 31 bzw. Anpasswandler 66, 67 ausgegeben. Sämtliche Funktionen des zu überprüfenden Differentialschutzsystems sind somit unter betriebsnahen Bedingungen zu testen, da beliebige Stromgrößen entsprechend der gewählten Fehlerarten simuliert werden können. Die einzeln getrennt steuerbaren Stromgeneratoren 39-41, 44 der Prüfeinrichtung 51 werden über Steuerbusleitungen 58-61, 64 vom Mikroprozessor 57 angesteuert und synchronisiert. Anhand eines im Mikroprozessor 57 ablaufenden Prüfprogramms können beliebige Prüfbedingungen simuliert werden, die den real zu erwartenden Betriebsbedingungen nachempfunden sind.

Im übrigen ist dargestellt, daß das Differentialschutzrelais 24 mindestens einen Schalter 52 aufweist, der über eine Leitung 53 und einem Binäreingang 56 mit der Prüfeinrichtung 51 verbunden ist. Über diesen Schalter 52 wird die Reaktion des Prüflings 24 ausgelesen und als Signal dem Binäreingang 56 zugeführt, damit die Prüfeinrichtung 51 die Antwort des Prüflings aufgrund der verschiedenen Prüfprogramme erfassen und verarbeiten kann.

Selbstverständlich ist es nicht erforderlich, die Prüfantwort in Form eines Schaltersignals an die Prüfeinrichtung weiterzuleiten; es können auch andere Signaleingänge in Frage kommen, mit denen die Reaktion des Prüflings erfaßt wird und mit zugeordneten, in der Prüfeinrichtung eingespeisten Parameter verglichen wird.

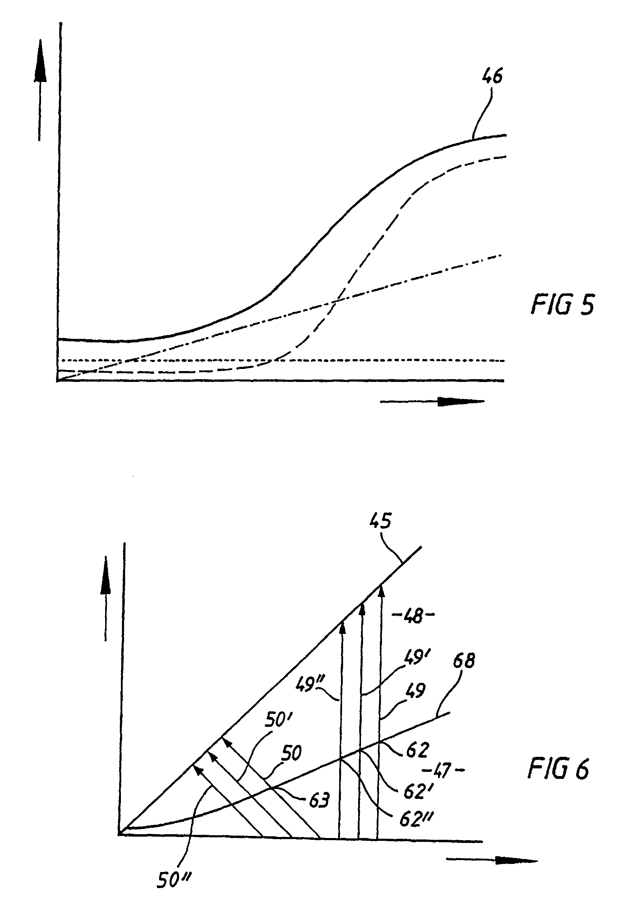

In Figur 5 ist anhand eines Diagramms die Abhängigkeit des Differentialstromes vom durchfließenden Strom (Stabilisierungsstrom) dargestellt.
Hierbei ist erkennbar, daß die resultierende betriebliche Differentialstromkennlinie 46 keine Gerade ist.

Der Differentialstrom I_{DIFF} wird gebildet aus der Differenz der angepassten transformierten Ströme I'_{PL} und I'_{SL} und ist eine reine Rechengröße zur Fehlererkennung.

Aus diesem Diagramm ergibt sich also, daß man verschiedene Fehlereinflüsse hat, was zur Folge hat, daß ein Schwellwert für die resultierende Auslösung des Schutzrelais nicht allein bei einem festen Wert von I_{DIFF} eingestellt werden darf.

Die betriebliche Differentialstromkennlinie 46 resultiert aus der Summation der verschiedenen betrieblichen Differentialströme in Abhängigkeit vom Stabilisierungsstrom.

In Figur 6 ist das Prüfverfahren in Form eines Diagramms dargestellt, und man erkennt, daß eine 45° geneigte Gerade 45 vorhanden ist, unterhalb der die Auslösekennlinie 68 des zu prüfenden Relais in Abhängigkeit von dem Differentialstrom und dem Stabilisierungsstrom eingezeichnet ist.

In dem Bereich unterhalb der Auslösekennlinie 68 soll das Relais stabilisieren, d.h. nicht auslösen, deshalb wird dieser Bereich Stabilisierungsbereich 47 genannt.

Oberhalb der Auslösekennlinie 68 soll das Relais auslösen, deshalb wird dieser Bereich als Auslösebereich 48 bezeichnet. Es sind eine Reihe von Prüfgeraden 49,49',49" eingezeichnet, die folgendes besagen:

Entlang dieser Prüfgeraden 49 werden Prüfpunkte gesetzt, die sowohl im Auslösebereich als auch im Stabilisierungsbereich liegen können.

Dies erfolgt mit dem Ziel, einen Arbeitspunkt auf dieser Auslösekennlinie zu finden, d.h. also genau den Schnittpunkt 62 zu ermitteln, bei dem das Relais auslöst oder genauer gesagt von dem Stabilisierungsbereich 47 in den Auslösebereich 48 übergeht.

Solche Prüfungen können in der gesamten Ebene wiederholt werden, um die gesamte sich in der Ebene erstreckende Auslösekennlinie 68 des Relais zu finden und darzustellen.

Es sind weitere Prüfgeraden 50,50',50" eingezeichnet, welche nach einem anderen Verfahren prüfen und die ebenfalls entsprechende Schnittpunkte 63 mit der Auslösekennlinie 68 ergeben.

Wichtig ist im übrigen auch, daß das gesamte Prüfprogramm nicht nur die aktuelle Lage der Auslösekennlinie 68 ermittelt, sondern auch automatisch einen Soll-Ist-Vergleich zwischen der vom Hersteller angegebenen Auslösekennlinie und der tatsächlich ermittelten Auslösekennlinie entsprechend der spezifischen Toleranzangaben durchführt.

Die Prüfeinrichtung berechnet anhand der spezifizierten Schutzobjektparameter entsprechend von den I_{DIFF} und I_{STAB} Werten die einzuspeisenden primären, sekundären und tertiären Prüfströme.

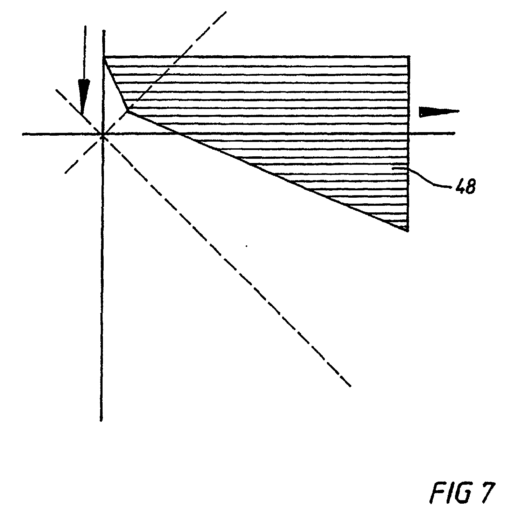

Figur 7 zeigt das Kennlinienfeld Iₛ = f(Iₚ) der beiden virtuellen (angepassten) Ströme der zu vergleichenden Enden. Dieses Kennlinienfeld erhält man, wenn man entsprechend der Geraden 50, 50', 50'' in Figur 6 prüft. Figur 7 ist daher lediglich eine andere Darstellung des Zusammenhangs I_{DIFF} = f(I_{STAB}).

### Zeichnungslegende

- 1: Schutzobjekt
- 2: Primärwicklung
- 3: Sekundärwicklung
- 4: Tertiärwicklung
- 5: Einspeisung (primärseitig)
- 6: Einspeisung (sekundärseitig)
- 7: Drehstromleitung (primär)
- 8: Drehstromleitung (sekundär)
- 9: Drehstromleitung (tertiär)
- 10: Stromwandler
- 11: Stromwandler
- 12: Stromwandler
- 13: Stromwandler
- 14: Stromwandler
- 15: Leitung
- 16: Leitung
- 17: Schalter
- 18: Schalter
- 19: Erde
- 20: Fehlerort
- 21: Fehlerort
- 22: Fehlerort
- 23: Last
- 24: Differentialschutzrelais (numerisch)
- 25: Leitung
- 26: Leitung
- 27: Leitung
- 28: Leitung
- 29: Leitung
- 30: Eingangswandler
- 31: Eingangswandler
- 32: Leitung
- 33: Leitung
- 34: Leitung
- 35: Leitung
- 36: Haltewicklung (primär)
- 37: Haltewicklung (sekundär)
- 38: Differentialwicklung
- 39: Stromgenerator (primär)
- 40: Stromgenerator (sekundär)
- 41: Stromgenerator (tertiär)
- 42: Prüfschalter
- 43: Prüfschalter
- 44: Stromgenerator
- 45: Gerade
- 46: Auslösekennlinie
- 47: Stabilisierungsbereich
- 48: Auslösebereich
- 49: Prüfgeraden
- 50: Prüfgeraden
- 51: Prüfeinrichtung
- 52: Schalter
- 53: Leitung
- 54: Testanordnung
- 55: Testanordnung
- 56: Binäreingang
- 57: Mikroprozessor
- 58: Steuerbus
- 59: Steuerbus
- 60: Steuerbus
- 61: Steuerbus
- 62: Schnittpunkt
- 63: Schnittpunkt
- 64: Steuerbus
- 65: Differentialrelais (konventionell)
- 66: Anpasswandler
- 67: Anpasswandler
- 68: Auslösekennlinie

## Patentansprüche

1. Verfahren zur Prüfung von Schutzeinrichtungen von Betriebsmitteln (1), wobei
das durch die Schutzeinrichtung zu schützende Betriebsmittel (1) mit allen seinen wichtigsten Parametern mittels einer Software in einer Prüfeinrichtung (51) simuliert wird,
die in der Simulation berechneten, vom zu schützenden Betriebsmittel (1) und weiteren Parametern abhängigen Prüfströme an die an die Prüfeinrichtung (51) angeschlossene Schutzeinrichtung ausgegeben werden, und
die Prüfeinrichtung (51) anhand der angelegten Prüfströme das Betriebs- und Fehlerverhalten der Schutzeinrichtung erfasst und entsprechend den spezifizierten Toleranzangaben der Schutzeinrichtung auswertet,
**dadurch gekennzeichnet, daß** die Schutzeinrichtung (24) als Differentialschutzrelais/-system (24) ausgebildet ist und daß die Vorgabe der Prüfströme unter Verwendung der Auslösekennlinie (68) I_{DIFF} = f(I_{STAB}) erfolgt, mit I_{DIFF} = Differentialstrom und I_{STAB} = Stabilisierungsstrom, wobei die Prüfeinrichtung (51) automatisch die notwendigen sekundären Prüfströme in Abhängigkeit vom simulierten Betriebsmittel, der Stromwandlerverhältnisse, der Fehlerart und des Fehlerortes berechnet und an das zu prüfende Differentialschutzrelais/-system (24) ausgibt.

2. Verfahren nach Anspruch 1, **dadurch gekennzeichnet, daß** eine 3-phasige Ankopplung der Prüfströme an das zu prüfende Differentialschutzrelais/-systems (24) erfolgt.

3. Verfahren nach einem der Ansprüche 1 oder 2, **dadurch gekennzeichnet, daß** das zu prüfende Differentialschutzrelais/-system (24) gleichzeitig mit mehreren synchronisierten Prüfströmen beaufschlagt wird, welche alle einzeln und unabhängig in Betrag und Phasenlage regelbar sind.

4. Verfahren nach Anspruch 2, **dadurch gekennzeichnet, daß** die mehrseitige, 3-phasige sekundäre Stromeinspeisung und schutzsystembezogene Prüfung in Ergänzung zu anderen bestehenden Prüfverfahren die bisher bei Transformatoren durchgeführte Primärstromprüfung bei Inbetriebnahme ersetzt bzw. ergänzt.

5. Verfahren nach einem der Ansprüche 1 bis 4, **dadurch gekennzeichnet, daß** die Simulation des zu schützenden Betriebsmittels (1), die Prüfströmeberechnung, die Prüfströmegenerierung, die Prüfablaufsteuerung und die Ereignisverarbeitung und -auswertung über eine entsprechende Software erfolgt.

## Claims

1. Method for testing protective devices of equipment (1), wherein
the equipment (1) to be protected by the protective device with all its leading parameters is simulated by software in a test device (51),
the test currents calculated in the simulation as a function of the equipment (1) to be protected and further parameters are fed to the protective device connected to the test device (51), and
the test device (51) detects the operational and defect behaviour of the protective device by means of the test currents applied and evaluates the protective device according to specified tolerance data,
**characterized in that** the protective device (24) is configured as a differential protective relay/ system (24) and **in that** the test currents are set by utilizing the release characteristic (68) I_{DIFF} = f(I_{STAB}), where I_{DIFF} = differential current and I_{STAB} = stabilizing current, the test device (51) automatically calculating the necessary secondary test currents as a function of the simulated equipment, current-transformer parameters, and type and location of defect, and feeding them to the differential protective relay/ system (24) to be tested.

2. Method according to Claim 1, **characterized in that** a 3-phase coupling of test currents is made to the differential protective relay/ system (24) to be tested.

3. Method according to Claim 1 or Claim 2, **characterized in that** a plurality of synchronized test currents, all separately and independently adjustable in intensity and phase position, are simultaneously fed to the differential protective relay/ system (24) to be tested.

4. Method according to Claim 2, **characterized in that** the multilateral 3-phase secondary current feed and protective-system testing in combination with other existing testing methods replaces or supplements the primary current testing hitherto performed on transformers upon commissioning.

5. Method according to any one of Claims 1 to 4, **characterized in that** the simulation of the equipment (1) to be protected, the calculation of the test currents, the generation of the test currents, the control of the test sequence and the event handling and evaluation are conducted by a corresponding software.

## Revendications

1. Procédé pour contrôler des dispositifs de protection d'éléments électriques (1),
selon lequel l'élément électrique (1) à protéger grâce au dispositif de protection est soumis avec tous ses paramètres essentiels à une simulation dans un dispositif de contrôle (51), à l'aide d'un logiciel,
les courants d'essai qui sont calculés lors de la simulation et qui dépendent de l'élément électrique (1) à protéger et d'autres paramètres sont transmis au dispositif de protection relié au dispositif de contrôle (51), et
à l'aide des courants de contrôle appliqués, le dispositif de contrôle (51) détecte le comportement de service ou le comportement incorrect du dispositif de protection et l'évalue suivant les indications de tolérances spécifiées du dispositif de protection,
**caractérisé en ce que** le dispositif de protection (24) est conçu comme un relais/système de protection différentiel (24) et **en ce que** les courants d'essai sont prédéfinis à l'aide de la courbe caractéristique de déclenchement (68) I_{DIFF}=f(I_{STAB}), avec I_{DIFF} = courant différentiel et I_{STAB} = courant de stabilisation, le dispositif de contrôle (51) calculant automatiquement les courants d'essai secondaires nécessaires, en fonction de l'élément électrique soumis à la simulation, des conditions de convertisseur de courant, du type d'erreur et de l'emplacement de l'erreur, et les transmettant au relais/système de protection différentiel (24) à contrôler.

2. Procédé selon la revendication 1, **caractérisé en ce qu'**un couplage triphasé des courants d'essai au relais/système de protection différentiel (24) à contrôler a lieu.

3. Procédé selon la revendication 1 ou 2, **caractérisé en ce que** le relais/système de protection différentiel (24) à contrôler est sollicité simultanément avec plusieurs courants d'essai synchronisés dont la valeur et la position de phase sont réglables individuellement et indépendamment.

4. Procédé selon la revendication 2, **caractérisé en ce que** l'alimentation plurilatérale en courant secondaire triphasé et le contrôle concernant le système de protection, en complément d'autres procédés de contrôle existants, remplace ou complète lors de la mise en marche le contrôle de courant primaire effectué jusqu'à présent au niveau de transformateurs.

5. Procédé selon l'une des revendications 1 à 4, **caractérisé en ce que** la simulation de l'élément électrique (1) à protéger, le calcul de courants d'essai, la production de courants d'essai, la commande de déroulement de contrôle et le traitement et l'évaluation des événements se font grâce à un logiciel approprié.
